# EUROPEAN PATENT APPLICATION

(11) **EP 2 657 965 A1**
(43) Date of publication of application: **30.10.2013**
(21) Application number: 12002887.3
(22) Date of filing: 24.04.2012
(51) Int. Cl.: H01L 23/34, F21Y 101/02

(54) **Heat disperser with heat transmission, heat convection and heat radiation function**

(71) Applicant: Ceramate Technical Co., Ltd, Taoyuan County (TW)
(72) Inventor: Wang, Robert, Luch Taoyuan County (TW)
(74) Representative: Volpert, Marcus

(57) **Abstract**

A heat disperser with heat transmission, heat convection and heat radiation function includes a body (10) made of a material able to easily conduct heat. The body (10) is formed into a continuous S shape by repeated bending, making up plural heat dispersing sheets (11) connected with plural heat dispersing walls (12), with two ends of each heat dispersing sheet (11) connected with one end of two heat dispersing walls (12), with two ends of each heat dispersing wall (12) connected with one end of two heat dispersing sheets (11). Then the heat disperser is combined with a heat producing element, whose heat is transmitted to the body (10). Then the body (10) has a large area for heat dispersing into open air by means of heat transmission, heat convection and heat radiation synchronously.

## Description

### BACKGROUND OF THE INVENTION

### 1. Field of the Invention

This invention relates to a heat disperser.

### 2. Description of the prior art

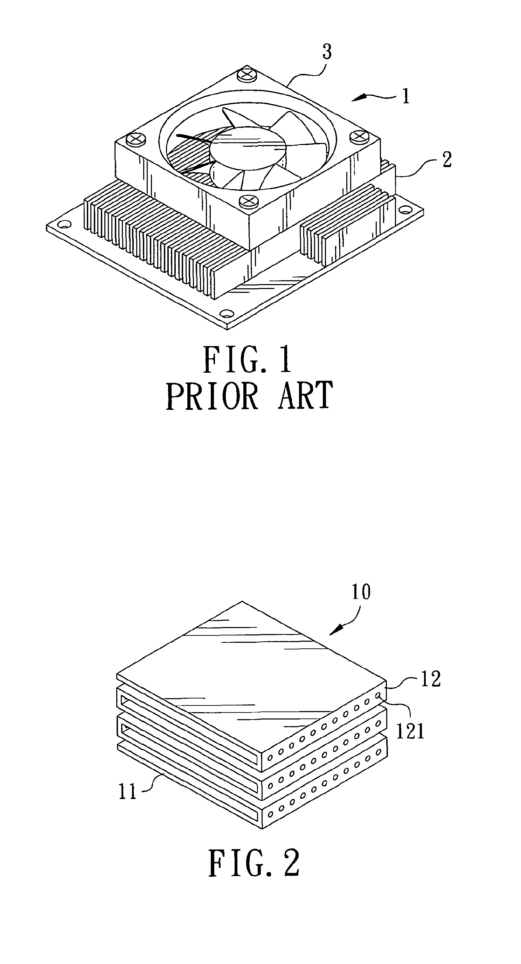

When an automobile, a motorcycle, or an electronic element operates, it always produces some heat. If the produced high heat cannot be dispersed out, its operation may be affected, losing its stability and shortening its service life. The higher the temperature is, the shorter becomes its service life. Referring to Fig. 1, an example of a heat disperser 1 attached with some product for dispersing the heat of the product into open air by means of natural heat convection and heat radiation, so that the product may be prevented from burned up.

After the product has been used for a long period of time, the heat disperser 1 may reach a heat saturation, leaving heat energy accumulating around the heat disperser 1 and the product, giving impact to the performance and stability, reducing its service life, with users subject to potential injuries in case of careless touching the heat disperser or the product. Generally, conventional heat dispersers are made of metal materials having high density and high heat conducting rates so that the heat saturation of the heat disperser 1 may be increased, and at the same time, the dispersing area may be expanded by using many flat fins 2. Though it may have good heat conductivity, high heat transmitting and processing and shaping facility, it may also has a large specific gravity, bad electrical insulation, heavy pollution by processing, low productivity, high cost, and injuries by careless ouch with the hot disperser so that competitive power in the market may be lessened not a little. Therefore it is imperative to offer a kind of heat disperser that can protect environment, save energy, be made with swiftness, decrease cost, have a light specific gravity, cause no injuries to users, and have heat transmission, heat convection and heat radiation function at the same time.

### SUMMARY OF THE INVENTION

The purpose of the invention is to offer a heat disperser of low cost, having high heat saturation, able to prevent injuries of a user, and equipped with heat transmission, heat convection and heat radiation function synchronously

The heat disperser according to the present invention includes a body made of a material able to easily conduct heat, made into a continual S-shape by repeatedly bending, formed into plural flat heat dispersing sheets alternately connected with plural vertical heat dispersing walls. Each flat heat dispersing sheet has two ends respectively connected with a corresponding end of two vertical heat dispersing walls, and each vertical heat dispersing wall has two ends respectively connected with a corresponding end of two flat heat dispersing sheets. Further, each vertical heat dispersing wall has a hole at least for air to flow through

Therefore, the heat disperser according to the invention can be combined with a heat producing element, which transmits heat to the heat disperser when heat is produced to protect the heat producing element from damaged by overheat. The body of the heat disperser has a large area to contact open air because of plural heat dispersing sheets and plural heat dispersing walls, so the heat dispersing dimensions and distance of the body are extensive. In addition, the air in the body can flow quickly through the holes of the vertical heat dispersing walls by means of heat convection, reinforcing heat dispersing effect. Therefore, the heat producing element can be lowered in its temperature swiftly, prevented from damaged by overheat, with its service life prolonged. Besides, even if a user should touch the body carelessly, he or she might not be harmed as it could not become too hot..Moreover, the invention can be made integral by injecting shooting, useful to protect environment from pollution and to save energy, fast to manufacture, high in productivity, and low in cost, having a small specific gravity, and enhancing competitive power in the market.

### BRIEF DESCRIPTION OF THE DRAWINGS

Fig. 1 is a perspective view of a conventional heat disperser;
Fig. 2 is a perspective view of a heat disperser in the present invention;
Fig. 3 is a cross-sectional view of a first preferred embodiment of the heat disperser in the present invention;
Fig. 4 is a lengthwise cross-sectional view in Fig. 3;
Fig. 5 is a cross-sectional view of an AA line in Fig. 4;
Fig. 6 is a perspective view of a second preferred embodiment of a heat disperser in the present invention; and
Fig 7 is a lengthwise cross-sectional view of Fig 6.

### DETAILED DESCRIPTION OF THE INVENTIION

A heat disperser in the present invention, as shown in Fig. 2, generally includes a body 10.

The body 10 is made of a material able to easily conduct heat and formed by means of injecting shooting. In the embodiments of the present invention, the body 10 uses plastics added with one kind of aluminum, carbon, ceramic or porcelain, having a continual S shape by repeated bending, making up plural flat heat dispersing sheets 11 and plural vertical heat dispersing walls 12 alternately connected with one another. Two ends of each heat dispersing sheet 11 are respectively connected with a corresponding end of two heat dispersing walls. Two ends of each heat dispersing wall 12 are respectively connected with a corresponding end of two heat dispersing sheets 11. Further, each heat dispersing wall 12 has a hole at least.

In order to further understand the structural features, operational means and expected effects of the present invention, details for using the heat dispersers of the invention is to be described below.

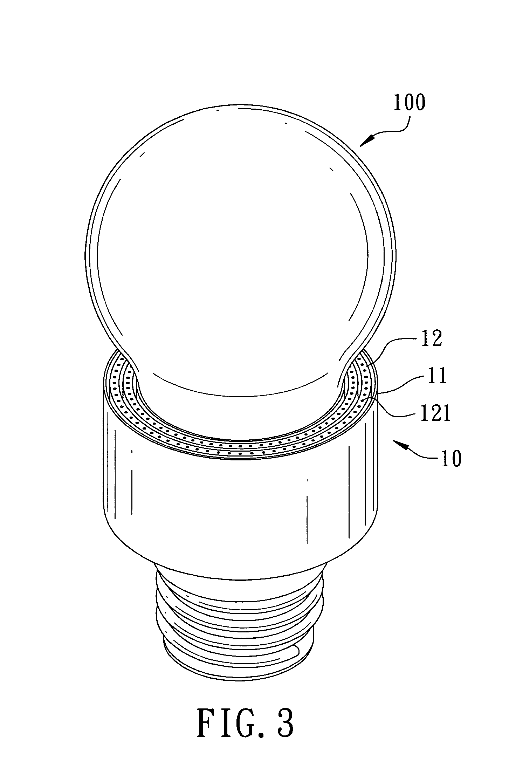

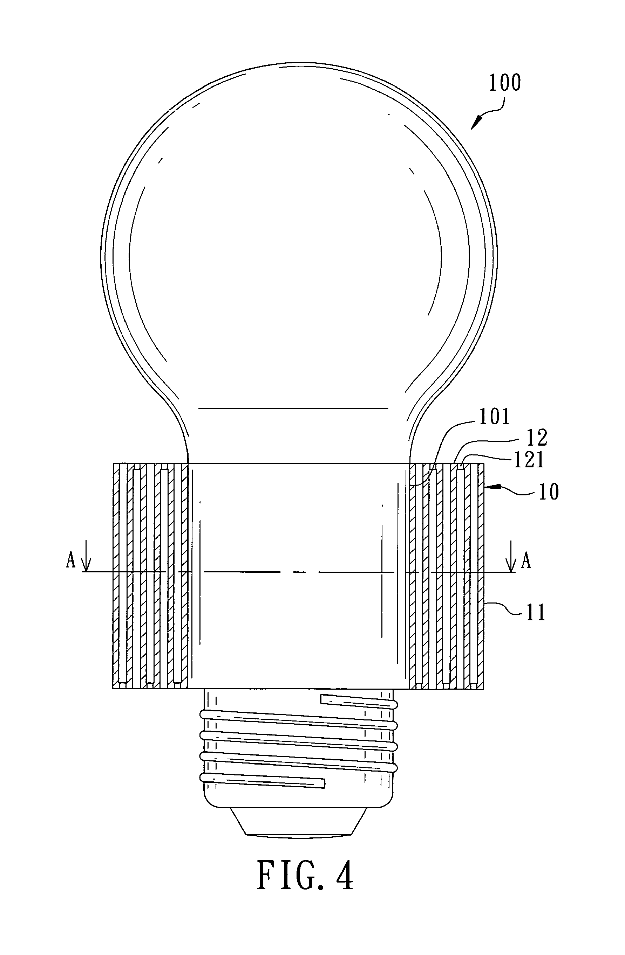

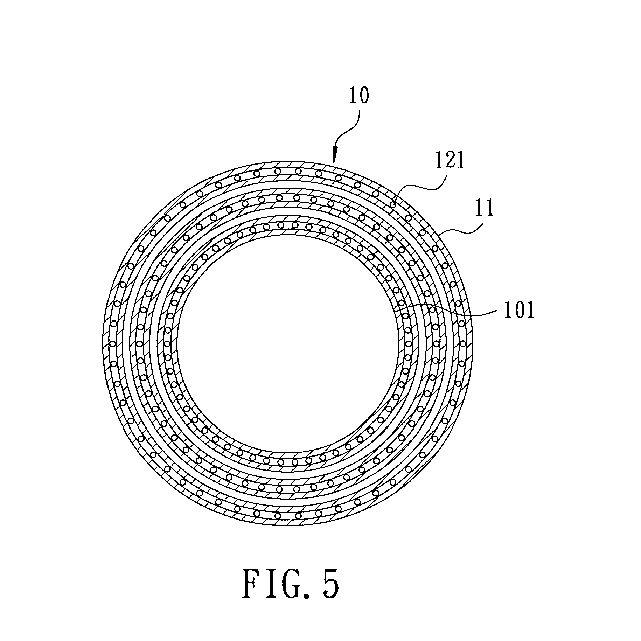

Referring to Figs. 3, 4 and 5, they show a first preferred embodiment of the heat disperser in the present invention. At first the body 10 is combined with a heat producing element such as a light 100, and one end of the body 10 or the heat dispersing sheet 11 first is wrapped around the base 101 of the light 100, and then other heat dispersing sheets 11 are also wrapped around continuously, forming plural concentric cylinders, with the heat dispersing walls 12 alternately connected with the heat dispersing sheets 11. Because two ends of each heat dispersing sheet 11 are respectively connected with a corresponding end of two heat dispersing walls 12, and two ends of each heat dispersing wall 12 are respectively connected with a corresponding end of two heat dispersing sheets 11, as described before. After the light 100 is electrified to light up, part of the consumed electricity becomes heat energy, so the temperature of the light 100 may gradually rise up, transmitting its heat to the body 10 so that the heat energy produced by the light 100 may be swiftly dispersed into open air by means of the body 10 equipped with an extensive dimensions and courses contacting with open air for dispersing the heat quickly. In addition, the heat dispersing walls 12 are provided with plural little holes 121 to enable the hot air in the body to flow swiftly out to form air convection, enhancing dispersing speed and lowering the temperature of the light 100. Thus, the light 100 may not be damaged by overheat, accordingly prolonging its service life. Therefore, a user may not be scolded even in case of careless touch with the body 10, as the body 10 is provided with heat dispersing courses, large heat dispersing areas, good heat dispersing speed, enabling a user to disconnect the body 10 from the light 100 without danger. Once the heat dispersing effect is enhanced by the body 10, the dimensions of the light 100 can be reduced, raising the using power of the light 100. Besides, the heat disperser in the invention can be made with one process of shaping by injecting shooting method, simplifying its manufacturing process, lowering its cost, and strengthening competitive power in the market.

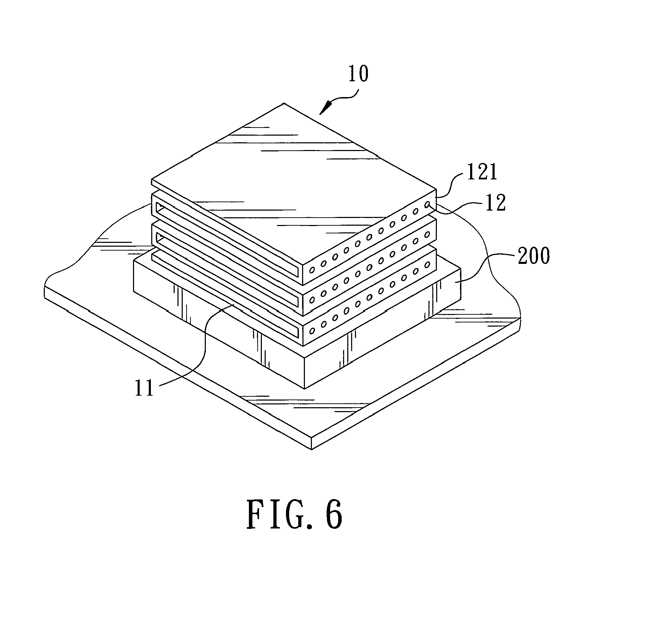

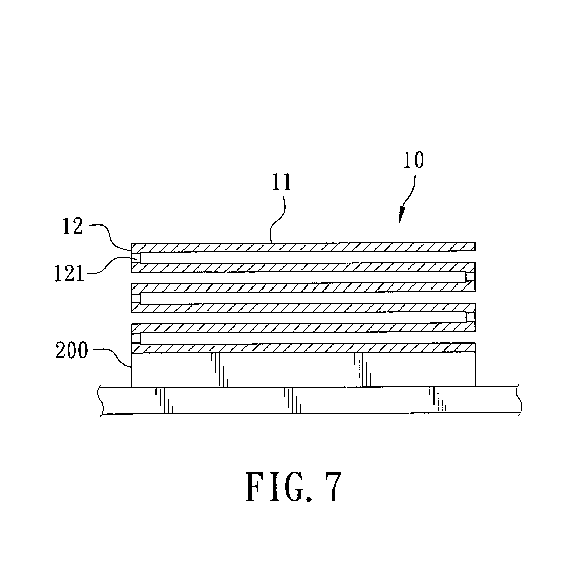

Next, Figs. 6 and 7 show a second preferred embodiment of the invention, having the body 10 combined with a heat producing element, and in this embodiment the heat producing element is a CPU (central processing unit) 200. One end of the body 10 is located on the upper surface of the CPU 200, with the plural heat dispersing sheets 11 lengthwise and alternately placed, with the two ends of each heat dispersing wall 12 connected with a corresponding end of two heat dispersing sheets 11. Furthermore, each heat dispersing wall 12 is provided with one hole 121 at least. Thus, the body 10 is equipped with various heat dispersing courses, large heat dispersing areas by means of the heat dispersing sheets 11 and the heat dispersing walls 12. Then the body 10 can have functions of heat transmission, heat convection, and heat radiation so as to boost up heat dispersing speed, prolonging the service life of the heat disperser, and preventing a user from getting injured. In addition, the heat disperser can be made integral quickly by process of injecting shooting simply, lowering its cost and enhancing competitive power in the market.

While the preferred embodiment of the invention has been described above, it will be recognized and understood that various modifications may be made therein and the appended claims are intended to cover all such modifications that may fall within the spirit and scope of the invention.

## Claims

1. A heat disperser with heat transmission, heat convention, and heat radiation function, said heat disperser comprising:
a body made of a material able to easily conduct heat, said body made into a continuous bent S shape to make up plural flat heat dispersing sheets and plural vertical heat dispersing walls, said each flat heat dispersing sheet having two ends connected respectively with said vertical heat dispersing wall, said each vertical heat dispersing wall having two ends connected respectively with a corresponding end of two said flat heat dispersing sheets, each said vertical heat dispersing wall having a hole at least; and
said body having one end connected with a heat producing element, said heat producing element able to transmit heat to said body, said body having a large area contacting open air to disperse heat into open air, said body thus increasing heat dispersing effect by means of heat transmission, heat convection and heat radiation function synchronously.

2. The heat disperser as claimed in Claim 1, wherein said body is made of plastics added with one chosen from aluminum, carbon, ceramic or porcelain.

3. The heat disperser as claimed in Claim 1, wherein said body is made integral by means of injecting shooting.
